# EUROPEAN PATENT SPECIFICATION

(11) **EP 3 415 880 B1**
(45) Date of publication and mention of the grant of the patent: **30.12.2020**
(21) Application number: 17750031.1
(22) Date of filing: 16.01.2017
(51) Int. Cl.: G01J 1/44, G01J 1/02, H01L 39/22, H03K 19/195, H01L 39/10

(54) **SIGNAL PROCESSING CIRCUIT**
SIGNALVERARBEITUNGSSCHALTUNG
CIRCUIT DE TRAITEMENT DE SIGNAL

(30) Priority: 10.02.2016 JP 2016023303
(43) Date of publication of application: 19.12.2018
(73) Proprietor: National Institute of Information and Communications Technology, Tokyo 184-8795 (JP)
(72) Inventor: MIKI, Shigehito, Tokyo 184-8795 (JP); TERAI, Hirotaka, Tokyo 184-8795 (JP); YAMASHITA, Taro, Tokyo 184-8795 (JP); MIYAJIMA, Shigeyuki, Tokyo 184-8795 (JP)
(74) Representative: Dehns
(86) International application number: PCT/JP2017/001273
(87) International publication number: WO 2017/138306

(56) References cited:
- JP-A- 2005 257 453
- JP-A- 2009 232 311
- JP-A- 2013 019 777
- US-A1- 2005 051 726
- US-A1- 2015 355 019
- US-A1- 2016 003 672
- QINGYUAN ZHAO ET AL: "Counting rate enhancements in superconducting nanowire single-photon detectors with improved readout circuits", OPTICS LETTERS, OPTICAL SOCIETY OF AMERICA, US, vol. 39, no. 7, 1 April 2014 (2014-04-01), pages 1869-1872, XP001589246, ISSN: 0146-9592, DOI: 10.1364/OL.39.001869 [retrieved on 2014-03-21]
- KYOSUKE SANO ET AL: "Demonstration of single-flux-quantum readout circuits for time-of-flight mass spectrometry systems using superconducting strip ion detectors", SUPERCONDUCTOR SCIENCE AND TECHNOLOGY., vol. 28, no. 7, 15 June 2015 (2015-06-15), page 074003, XP55550906, GB ISSN: 0953-2048, DOI: 10.1088/0953-2048/28/7/074003
- M. S. ALLMAN ET AL.: 'A near-infrared 64-pixel superconducting nanowire single photon detector array with integrated multiplexed readout' APPL. PHYS. LETT. vol. 106, 2015, page 192601, XP012197475
- ADAM MCCAUGHAN ET AL.: 'Superconducting- nanowire single-photon-detector linear array' APPL. PHYS. LETT. vol. 103, 2013, page 142602, XP012175489
- JOSEPH C. BARDIN ET AL.: 'Cryogenic SiGe Integrated Circuits for Superconducting Nanowire Single Photon Detector Readout' P ROC. OF SPIE vol. 9114, 2014, page 911404, XP060037744

## Description

### Technical Field

The present disclosure relates to a signal processing circuit.

### Background Art

A superconducting single photon detector (hereinafter, referred to as an SSPD) has excellent characteristics such as high detection efficiency, a high temporal resolution (timing jitter), and a low dark count rate as compared with a conventional single photon detector (for example, an avalanche photodiode detector) and is expected to be used in various fields such as quantum information communications.

For such a superconducting single photon detection system, development of a superconducting single photon detector including one light receiver has been carried out, but in recent years, a superconducting single photon detector including a plurality of light receiver (pixels) (hereinafter, sometimes referred to as a "multi-pixel SSPD") has been proposed (see, for example, PTL1 and PTL 2).

The development of such a multi-pixel SSPD facilitates further enhancement of the superconducting single photon detection system such as allowing the superconducting single photon detection system to have, for example, a spatial resolution capability and a photon number determination capability, which in turn expands the use range of the superconducting single photon detection system.

Q Zhao et al. Optics Letters 39 (2014) shows a (single) SSPD with a readout circut that includes a branching unit ("power splitter") and moves the bias-T (i.e. the feed-in for the bias voltage onto one of the two branches after this power splitter, the high frequency branch of that T (i.e. the capacitively coupled branch) being connected to ground via a resistor.

M S Allman et al. Appl. Phys. Lett. 106 (2015) shows a multiplex read out for a multi-pixel SSPD, i.e. output signals from multiple detectors use common transmission lines.

Q Zhao et al. Appl. Phys. Lett. 103 (2013) shows a method or readout for a linear SSPD array, output lines being connected to each other and signal analysis for time and address performed on the combined signal.

J C Bardin et al. Proc. SPIE 9114 (2014) shows yet another readout method for a SSPD array where individual channels are combined before data analysis.

### Citation List

### Patent Literature

PTL 1: JP 2009-232311 A
PTL2: JP 2013-19777 A

### Summary of Invention

### Technical Problem

However, in the conventional example, deterioration of timing jitter (temporal resolution) due to an increase in the number of pixels of the multi-pixel SSPD has not sufficiently been examined. Note that the timing jitter refers to temporal fluctuations of timing at which the superconducting single photon detection system generates an output signal in response to incidence of a photon.

An aspect of the present disclosure provides a signal processing circuit that can suppress deterioration of timing jitter of a superconducting single photon detection system as compared with the conventional art even when the number of pixels of a multi-pixel SSPD increases.

### Solution to Problem

A signal processing circuit according to the aspect of the present disclosure is a circuit configured with a superconducting digital logic circuit and used for processing detection signals output from a plurality of superconducting single photon detectors (hereinafter, referred to as SSPDs). The signal processing circuit includes a plurality of transmission paths connected to the plurality of SSPDs on a one-to-one basis, a branching unit causing each of the transmission paths to branch into a first transmission path and a second transmission path, a time information generation circuit connected to the first transmission paths, and an address information generation circuit connected to the second transmission paths. The time information generation circuit outputs, based on the detection signals output from the plurality of SSPDs, a time (timing) information signal for identifying a time at which a photon is incident on the plurality of SSPDs, and the address information generation circuit outputs, based on the detection signals output from the plurality of SSPDs, an address information signal for identifying an SSPD on which a photon is incident from among the plurality of SSPDs.

### Advantageous Effects of Invention

The signal processing circuit according to the aspect of the present disclosure can suppress deterioration of the timing jitter of the superconducting single photon detection system as compared with conventional art even when the number of pixels of the multi-pixel SSPD increases.

### Brief Description of Drawings

Fig. 1 is a diagram showing an example of a signal processing circuit for a multi-pixel SSPD according to an embodiment.
Fig. 2 is a diagram showing an example of a signal processing circuit according to a first example of the embodiment.
Fig. 3 is a diagram used for explaining an operation of the signal processing circuit according to the first example of the embodiment.
Fig. 4 is a diagram showing an example of an output of the signal processing circuit according to the first example of the embodiment.
Fig. 5 is a diagram showing an example of a signal processing circuit according to a second example of the embodiment.
Fig. 6 is a diagram showing an example of an output of the signal processing circuit according to the second example of the embodiment
Fig. 7 is a diagram showing an example of a superconducting single photon detection system including a signal processing circuit according to a modification of the embodiment.
Fig. 8 is a diagram showing an example of a conventional signal processing circuit for a multi-pixel SSPD.

### Description of Embodiments

A relationship between a number of pixels of a multi-pixel SSPD and timing jitter of a superconducting single photon detection system has been studied intensively, and the following findings have been obtained.

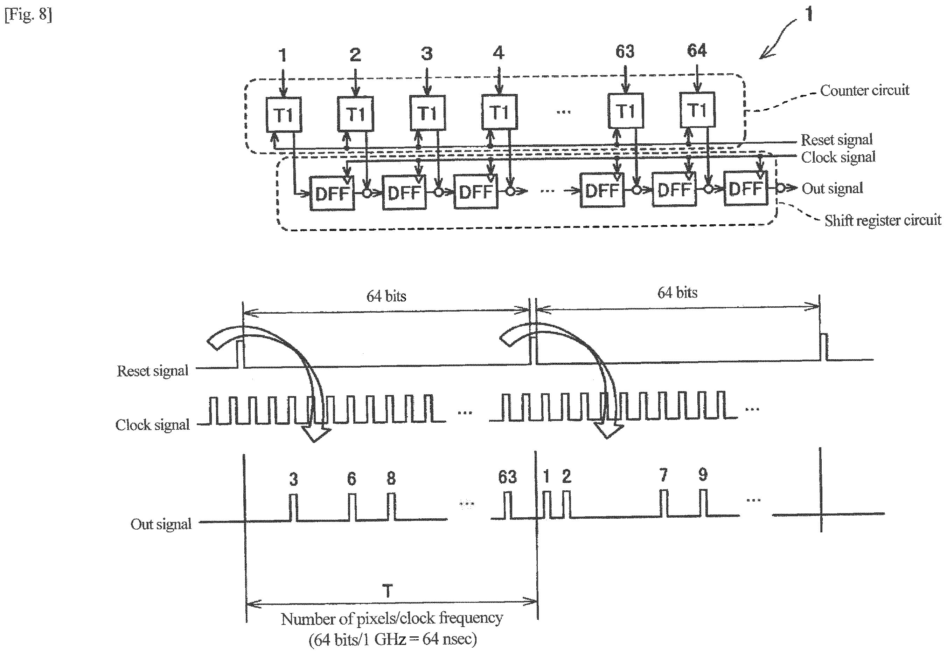

Fig. 8 is a diagram showing an example of a conventional signal processing circuit for a multi-pixel SSPD. A signal processing circuit 1 shown in Fig. 8 is a processing circuit for a multi-pixel SSPD capable of identifying a pixel where a photon is detected. Fig. 8 shows a block diagram and an operation sequence of the signal processing circuit 1 in a case where a multi-pixel SSPD whose pixel number is 64 is used.

As shown in Fig. 8, the signal processing circuit 1 includes a counter circuit comprised of 64 T-type flip-flops T1 (hereinafter, referred to as T1 cells) and a shift register circuit comprised of 64 D-type flip-flops DFF (hereinafter, referred to as DFF cells). Note that the T1 cells and the DFF cells are each configured with, for example, a single flux element (hereinafter, referred to as an SFQ) or the like.

In the counter circuit shown in Fig. 8, detection signals output from 64 SSPDs (not shown) are held in respective T1 cells. Then, pieces of information in the T1 cells are transferred to respective DFF cells in response to a reset signal from the outside. Next, pieces of information in the DFF cells are serially read out as an out signal from the shift register circuit in response to a clock signal from the outside, which allows a pixel where a photon is detected to be identified.

This configuration in which position information on the multi-pixel SSPD where the photon is detected is obtained allows the superconducting single photon detection system to be applied to, for example, high-sensitivity imaging.

Further, since the single flux element is used as an information carrier in the signal processing circuit 1, the signal processing circuit 1 can operate at a high speed with a minute signal, and power consumption of the signal processing circuit 1 can be reduced.

Furthermore, since originally required 64 output signal cables can be reduced to three output cables, that is, reset, clock, and out, an increase in thermal load during signal processing on the multi-pixel SSPD can be suppressed.

However, the inventors have found a problem that the increase in the number of pixels of the multi-pixel SSPD leads to deterioration of the timing jitter (temporal resolution) of the superconducting single photon detection system when the signal processing circuit 1 is used. Specifically, as shown in Fig. 8, a minimum unit of the timing jitter of the conventional superconducting single photon detection system is limited to a time interval T calculated by the number of pixels (bits)/a clock frequency. For example, when the clock frequency is 1 GHz and the number of pixels of the multi-pixel SSPD is 64 (64 bits), this time interval T is about 64 nanoseconds. In this case, even if a plurality of photons are incident on the multi-pixel SSPD within a time of about 64 nanoseconds, time information on these photons cannot be separately acquired.

Then, taking into consideration that the timing jitter of the SSPD is 100 picoseconds or less and the timing jitter of the SFQ circuit is several picoseconds, the above-described fact shows that the conventional superconducting single photon detection system is unable to fully exert the performance of these elements.

Therefore, the inventors have come up with an idea of separately generating the address information and the time information on the multi-pixel SSPD in order to suppress deterioration of the timing jitter in the superconducting single photon detection system even when the number of pixels of the multi-pixel SSPD increases.

That is, provided according to a first aspect of the present disclosure is a signal processing circuit configured with a superconducting digital logic circuit and used for processing detection signals output from a plurality of superconducting single photon detectors (hereinafter, referred to as SSPDs). The signal processing circuit includes a plurality of transmission paths connected to the plurality of SSPDs on a one-to-one basis, a branching unit causing each of the transmission paths to branch into a first transmission path and a second transmission path, a time information generation circuit connected to the first transmission paths, and an address information generation circuit connected to the second transmission paths. The time information generation circuit outputs, based on the detection signals output from the plurality of SSPDs, a time information signal for identifying a time at which a photon is incident on the plurality of SSPDs, and the address information generation circuit outputs, based on the detection signals output from the plurality of SSPDs, an address information signal for identifying an SSPD on which a photon is incident from among the plurality of SSPDs.

Such a configuration makes it possible to suppress deterioration of timing jitter of the superconducting single photon detection system as compared with the conventional art even when the number of pixels of the multi-pixel SSPD increases. Specifically, in the signal processing circuit according to the present aspect, address information and time information are separately generated. Therefore, optimizing the address information generation circuit in accordance with the number of pixels (scale) of the multi-pixel SSPD makes it possible to improve the timing jitter of the superconducting single photon detection system as compared with the conventional art.

In particular, taking into consideration that the timing jitter of the SSPD is 100 picoseconds or less and the timing jitter of the SFQ circuit is several picoseconds, the signal processing circuit according to the present aspect can contribute to attainment of timing jitter of 100 picoseconds or less in the superconducting single photon detection system.

Further, in a signal processing circuit according to a second aspect of the present disclosure, the time information generation circuit of the signal processing circuit according to the first aspect outputs a time information signal resulting from taking a logical sum of the detection signals output from the plurality of SSPDs.

Such a configuration allows a time at which a photon is incident on the multi-pixel SSPD to be appropriately acquired as a time information signal from the time information generation circuit.

Hereinafter, an embodiment of the present disclosure will be described in detail with reference to the drawings.

Note that the embodiment to be described below represents comprehensive or concrete examples. Numerical values, shapes, constituent elements, an arrangement and a topology of the constituent elements, and the like shown in the following embodiment are merely examples and are not intended to limit the present disclosure. Further, among the constituent elements in the following embodiment, a constituent element not described in the independent claim representing the top level concept is described as an optional constituent element.

### Embodiment

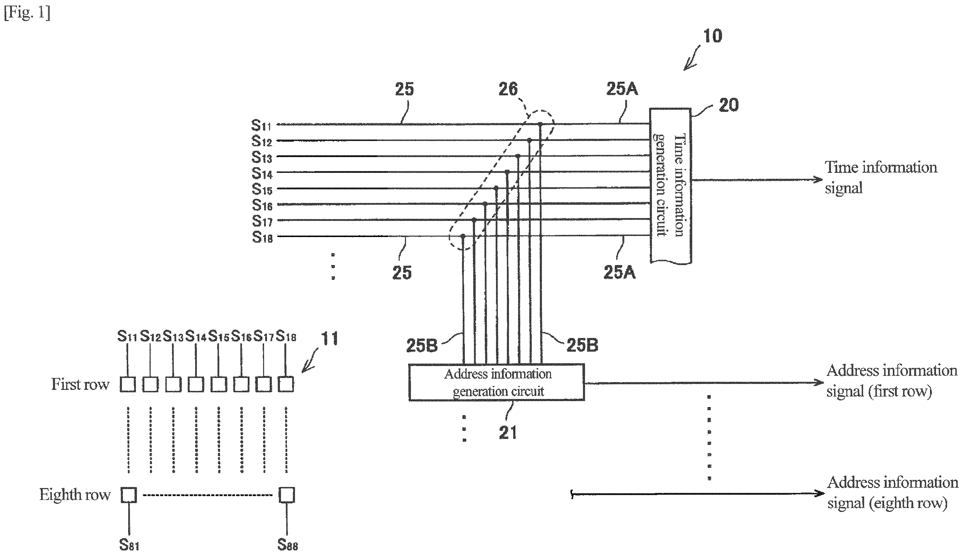

Fig. 1 is a diagram showing an example of a signal processing circuit for a multi-pixel SSPD according to an embodiment. Although a number and an arrangement of pixels of a multi-pixel SSPD 11 are freely set, Fig. 1 shows an example where 64 SSPDs (S_{NM} where N is in a range of 1 to 8, and M is in a range of 1 to 8) in the multi-pixel SSPD 11 are arranged in a matrix. Note that, for the purpose of making a configuration of a signal processing circuit 10 simple, Fig. 1 shows only eight transmission paths 25 respectively corresponding to eight SSPDs (S₁₁ to S₁₈) in a first row of the multi-pixel SSPD 11, and a description will be given below of signal processing on the SSPDs. Note that the same applies to signal processing on SSPDs in the second and subsequent rows.

As shown in Fig. 1, the signal processing circuit 10 includes transmission paths 25, a branching unit 26, a time information generation circuit 20, and an address information generation circuit 21.

The signal processing circuit 10 is configured with a superconducting digital logic circuit and is used for processing detection signals output from the eight SSPDs (S₁₁ to S₁₈).

Since an internal configuration and an operation of the SSPD are well known, the descriptions of the internal configuration and the operation will be omitted. In addition, the superconducting digital logic circuit may have any configuration as long as the superconducting digital logic circuit is capable of operating in a superconducting state. Examples of the superconducting digital logic circuit include an SFQ circuit, an adiabatic quantum flux parametron (QFP) circuit, a superconducting nanowire cryotron circuit, and a reciprocal quantum logic (RQL) circuit.

The transmission paths 25 are connected to the eight SSPDs (S₁₁ to S₁₈) on a one-to-one basis. The transmission paths 25 may have any configuration as long as the transmission paths 25 are capable of carrying detection signals (pulses) output from the SSPDs (S₁₁ to S₁₈). Examples of the transmission paths 25 include a coaxial cable.

The branching unit 26 causes each of the eight transmission paths 25 to branch into a first transmission path 25A and a second transmission path 25B.

The time information generation circuit 20 is connected to the first transmission paths 25A. Then, the time information generation circuit 20 outputs, based on the detection signals output from the multi-pixel SSPD 11, a time (timing) information signal for identifying a time at which a photon is incident on the multi-pixel SSPD 11. The time information generation circuit 20 may have any configuration as long as the time information generation circuit 20 is capable of outputting such a time information signal.

For example, the time information generation circuit 20 may be a circuit configured to output the time information signal resulting from taking a logical sum of detection signals output from the multi-pixel SSPD 11. Accordingly, whenever a photon is incident on any one of the SSPDs (S₁₁ to S₁₈) in the multi-pixel SSPD 11, a pulse signal is output from the time information generation circuit 20. Therefore, this pulse signal allows the time at which the photon is incident on the multi-pixel SSPD 11 to be identified and appropriately acquired as the time information signal from the time information generation circuit 20.

The address information generation circuit 21 is connected to the second transmission paths 25B. Then, the address information generation circuit 21 outputs, based on the detection signals output from the SSPDs (S₁₁ to S₁₈), an address information signal for identifying an SSPD on which a photon is incident from among the SSPDs (S₁₁ to S₁₈). The address information generation circuit 21 may have any configuration as long as the address information generation circuit 21 is capable of outputting such an address information signal. A specific example of the address information generation circuit 21 will be described in a first example and a second example.

Note that, herein, the time information generation circuit 20 and the address information generation circuit 21 use, for example, an SFQ as an information carrier in place of a conventional semiconductor element (for example, a complementary metal oxide semiconductor (CMOS) transistor). Since the principle of operation of the SFQ circuit is well known, the description of the principle of operation will be omitted. Accordingly, the signal processing circuit 10 has advantageous features in that the signal processing circuit 10 is capable of operating at a high speed and has low power consumption as compared with a conventional signal processing circuit comprised of semiconductor elements.

Accordingly, the signal processing circuit 10 can suppress deterioration of timing jitter of a superconducting single photon detection system as compared with the conventional art even when the number of pixels of the multi-pixel SSPD 11 increases. Specifically, in the signal processing circuit 10, address information and time information are separately generated. Therefore, optimizing the address information generation circuit 21 in accordance with the number of pixels (scale) of the multi-pixel SSPD 11 makes it possible to improve the timing jitter of the superconducting single photon detection system as compared with the conventional art.

In particular, taking into consideration that the timing jitter of the SSPD is 100 picoseconds or less and the timing jitter of the SFQ circuit is several picoseconds, the signal processing circuit 10 can contribute to attainment of the timing jitter of 100 picoseconds or less in the superconducting single photon detection system.

### First example

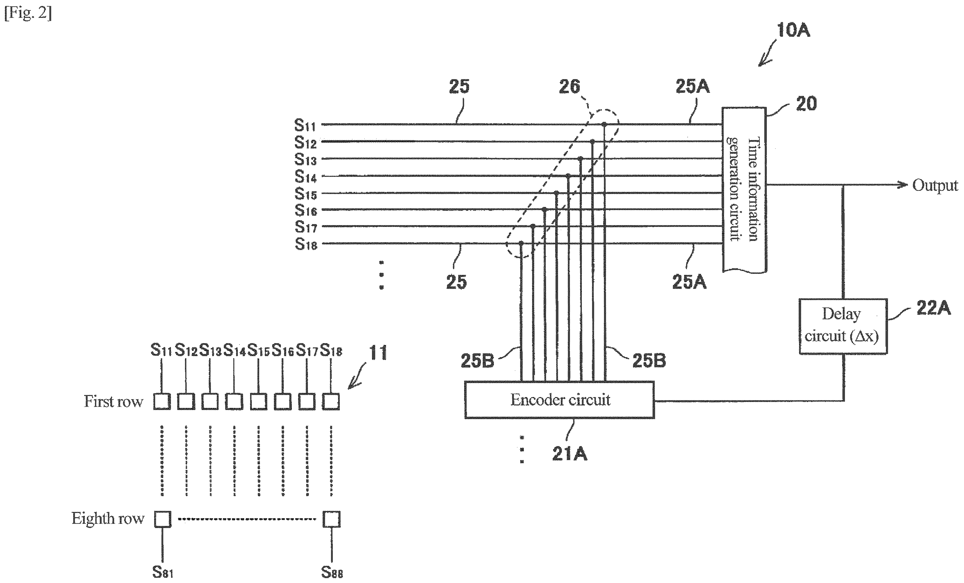

Fig. 2 is a diagram showing an example of a signal processing circuit according to the first example of the embodiment.

As shown in Fig. 2, a signal processing circuit 10A includes transmission paths 25, a branching unit 26, a time information generation circuit 20, an encoder circuit 21A, and a delay circuit 22A. The transmission paths 25, the branching unit 26, and the time information generation circuit 20 are the same as those in the embodiment; thus, the descriptions of the transmission paths 25, the branching unit 26, and the time information generation circuit 20 will be omitted.

The signal processing circuit 10A includes the encoder circuit 21A serving as the address information generation circuit 21. That is, the encoder circuit 21A is connected to the second transmission paths 25B. The encoder circuit 21A is configured to convert data corresponding to the detection signals output from the multi-pixel SSPD 11 into a binary code of a predetermined number of bits to generate a pulse train corresponding to this binary code.

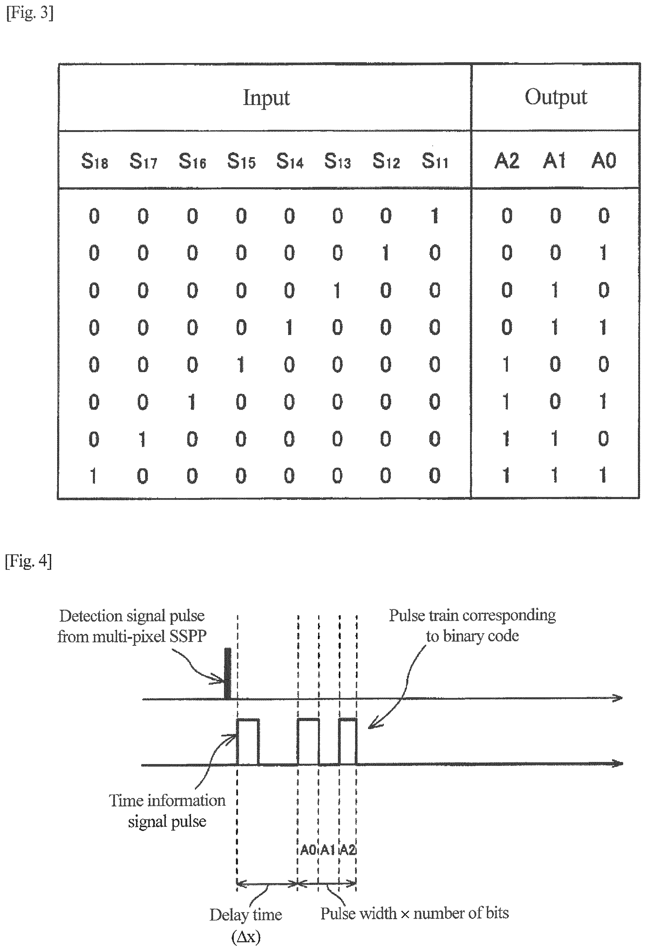

The encoder circuit 21A may have any configuration as long as the encoder circuit 21A is capable of generating such a pulse train. For example, in this example, as shown in a truth table of Fig. 3, on the assumption that a value input into the encoder circuit 21A when a photon is incident on any one of the eight SSPDs (S₁₁ to S₁₈) is "1", the encoder circuit 21A generates 3-bit output pulses (A2, A1, A0) corresponding to the binary digits.

The delay circuit 22A is a circuit for delaying an output timing of the pulse train from the encoder circuit 21A relative to a pulse of the time information signal. That is, the output of the encoder circuit 21A is transmitted to an output part of the time information generation circuit 20 via the delay circuit 22A. Specifically, the delay circuit 22A delays the output timing of the pulse train by a time interval (Δx) relative to the pulse of the time information signal.

Fig. 4 is a diagram showing an example of an output of the signal processing circuit according to the first example of the embodiment. Note that Fig. 4 shows a pulse train of a binary code generated when a photon is incident on an SSPD (S₁₆) among the eight SSPDs (S₁₁ to S₁₈).

As shown in Fig. 4, using the encoder circuit 21A serving as the address information generation circuit 21 allows the address information signal for identifying an SSPD on which a photon is incident from among the eight SSPDs (S₁₁ to S₁₈) to be represented by 3-bit output pulses (A2, A1, A0) generated by the encoder circuit 21A. That is, this configuration allows the address information signal to be identified by information that is smaller in size by 5 bits than the information used in the configuration where the encoder circuit 21A is not used.

Accordingly, the signal processing circuit 10A according to the present example can obtain the address information signal without serially reading out pulses whose number is equal to the number of pixels of the multi-pixel SSPD, which makes it possible to improve the timing jitter of the superconducting single photon detection system.

Further, using the delay circuit 22A allows the output (time information signal) of the time information generation circuit 20 and the output (address information signal) of the encoder circuit 21A to be clearly distinguished from each other.

The signal processing circuit 10C according to the present example may be identical in configuration to the signal processing circuit 10 according to the embodiment, except for the above-described features.

### Second example

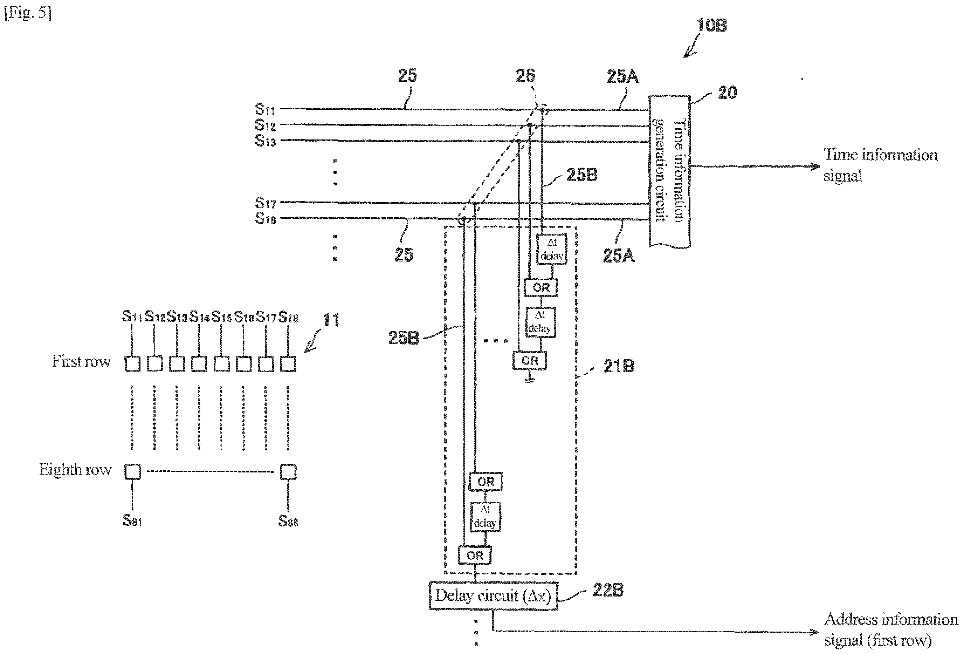

Fig. 5 is a diagram showing an example of a signal processing circuit according to the second example of the embodiment.

As shown in Fig. 5, a signal processing circuit 10B includes transmission paths 25, a branching unit 26, a time information generation circuit 20, a pulse position modulation circuit 21B, and a delay circuit 22B. The transmission paths 25, the branching unit 26, and the time information generation circuit 20 are the same as those in the embodiment; thus, the descriptions of the transmission paths 25, the branching unit 26, and the time information generation circuit 20 will be omitted.

The signal processing circuit 10B includes the pulse position modulation circuit 21B serving as the address information generation circuit 21. That is, the pulse position modulation circuit 21B is connected to the second transmission paths 25B. The pulse position modulation circuit 21B is configured to make delay times of detection signals transmitted through the second transmission paths 25B different from each other.

The pulse position modulation circuit 21B may have any configuration as long as the pulse position modulation circuit 21B is capable of making the delay times of the detection signals transmitted through the second transmission paths 25B different from each other. For example, as shown in Fig. 5, the pulse position modulation circuit 21B may be configured with seven delay circuits (Δt delay) and seven logical sum circuits (OR).

The delay circuit 22B is a circuit for delaying an output timing of a pulse from the pulse position modulation circuit 21B relative to a pulse of the time information signal. For example, when a photon is incident on an SSPD (S₁₈), the delay circuit 22B delays the output timing of the pulse from the pulse position modulation circuit 21B by the time interval (Δx) relative to the pulse of the time information signal.

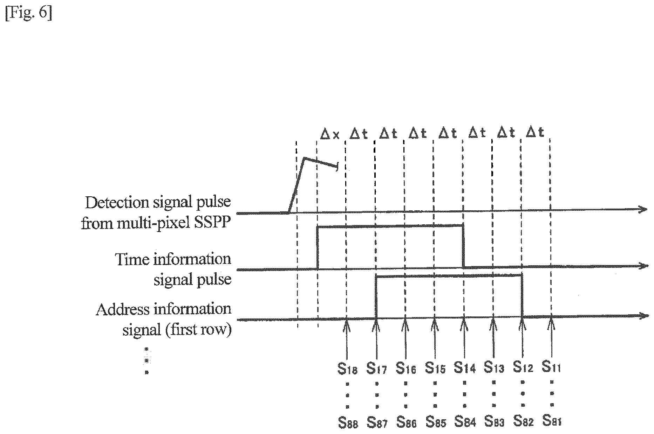

Fig. 6 is a diagram showing an example of an output of the signal processing circuit according to the second example of the embodiment.

As shown in Fig. 6, using the pulse position modulation circuit 21B serving as the address information generation circuit 21 allows the address information signal for identifying an SSPD on which a photon is incident from among the eight SSPDs (S₁₁ to S₁₈) to be represented in accordance with the output timing of the pulse from the pulse position modulation circuit 21B.

Fig. 6 shows pulses output from the pulse position modulation circuit 21B when a photon is incident on an SSPD (S₁₇) among the eight SSPDs (S₁₁ to S₁₈) in the first row. When a photon is incident on the SSPD (S₁₇) in the first row, a conesponding pulse output from the pulse position modulation circuit 21B is output via the delay circuit 22B and one of the delay circuits (Δt delay). Therefore, the output timing of this pulse is delayed by a time interval (Δx + Δt) relative to the output timing of the pulse of the time information signal. That is, detecting the output timing of the pulse from the pulse position modulation circuit 21B allows an SSPD on which a photon is incident to be identified from among the eight SSPDs (S₁₁ to S₁₈) in the first row.

Accordingly, the signal processing circuit 10B according to the present example can obtain the address information signal without serially reading out pulses whose number is equal to the number of pixels of the multi-pixel SSPD, which makes it possible to improve the timing jitter of the superconducting single photon detection system.

Further, using the delay circuit 22B allows the output (time information signal) of the time information generation circuit 20 and the output (address information signal) of the pulse position modulation circuit 21B to be clearly distinguished from each other.

The signal processing circuit 10B according to the present example may be identical in configuration to the signal processing circuit 10 according to the embodiment, except for the above-described features.

### Modification

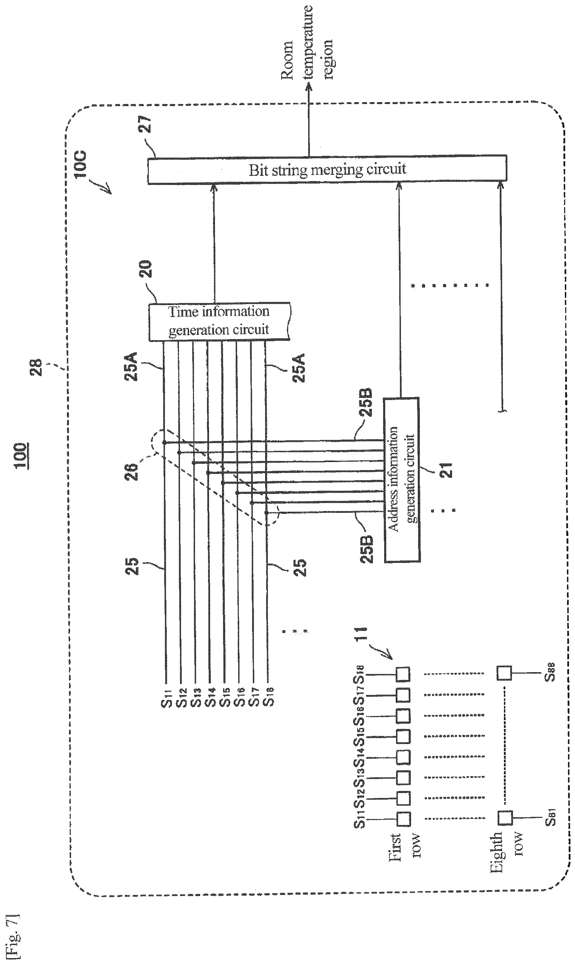

Fig. 7 is a diagram showing an example of a superconducting single photon detection system including a signal processing circuit according to a modification of the embodiment.

As shown in Fig. 7, a signal processing circuit 10C of a superconducting single photon detection system 100 includes transmission paths 25, a branching unit 26, a time information generation circuit 20, an address information generation circuit 21, a bit string merging circuit 27. The transmission paths 25, the branching unit 26, the time information generation circuit 20, and the address information generation circuit 21 are the same as those in the embodiment; thus, the descriptions of the transmission paths 25, the branching unit 26, the time information generation circuit 20, and the address information generation circuit 21 will be omitted.

The bit string merging circuit 27 outputs, through a single transmission path, a time information signal transmitted through a transmission path and a plurality of address information signals transmitted through transmission paths (eight transmission paths in this example).

The signal processing circuit 10C operates in the superconducting state; thus, the signal processing circuit 10C is cooled to a cryogenic temperature by a cooler 28 (for example, a Gifford-McMahon (GM) cooler) together with the multi-pixel SSPD 11. Therefore, a configuration where the bit string merging circuit 27 is not used causes the number of coaxial cables constituting the transmission paths to increase due to an increase in the number of pixels of the multi-pixel SSPD 11, which in turn causes thermal load on (an amount of heat intrusion to) the cooler 28 to become large. In this case, there is a possibility of making installation of the signal processing circuit in the cooler 28 difficult; however, such a possibility can be reduced because the signal processing circuit 10C according to the present modification is configured as described above such that only a single coaxial cable extends toward an external room temperature region.

The signal processing circuit 10C according to the present modification may be identical in configuration to the signal processing circuit 10 according to the embodiment, except for the above-described features.

Note that the embodiment, the first example, the second example, and the modification may be combined with each other unless the embodiment, the first example, the second example, and the modification are mutually exclusive. Further, from the above description, it will be apparent to those skilled in the art that many modifications and other embodiments of the present disclosure may be made. Accordingly, the above description should be construed as illustrative only, and is provided for the purpose of teaching those skilled in the art the best mode of carrying out the present disclosure. It is possible to substantially change the details of the structure and/or function of the present disclosure without departing from the scope of the present invention as defined by the claims..

### Industrial Applicability

One aspect of the present disclosure can be used, for example, as a signal processing circuit for a multi-pixel SSPD.

### Reference Signs List

- 10: signal processing circuit
- 10A: signal processing circuit
- 10B: signal processing circuit
- 10C: signal processing circuit
- 20: time information generation circuit
- 21: address information generation circuit
- 21A: encoder circuit
- 21B: pulse position modulation circuit
- 22A: delay circuit
- 22B: delay circuit
- 25: transmission path
- 25A: first transmission path
- 25B: second transmission path
- 26: branching unit
- 27: bit string merging circuit
- 28: cooler
- 100: superconducting single photon detection system

## Claims

1. A signal processing circuit configured with a superconducting digital logic circuit and configured for processing detection signals output from a plurality of superconducting single photon detectors, SSPD, (100), the signal processing circuit comprising:
a plurality of transmission paths (25) connected to the plurality of SSPDs on a one-to-one basis;
a branching unit (26) that causes each of the transmission paths to branch into a first transmission path (25A) and a second transmission path (25B);
a time information generation circuit (20) connected to the first transmission paths; and
an address information generation circuit (21) connected to the second transmission paths,
wherein
the time information generation circuit is configured to output, based on the detection signals output from the plurality of SSPDs, a time (timing) information signal for identifying a time at which a photon is incident on the plurality of SSPDs, and
the address information generation circuit is configured to output, based on the detection signals output from the plurality of SSPDs, an address information signal for identifying an SSPD on which a photon is incident from among the plurality of SSPDs.

2. The signal processing circuit according to claim 1, wherein
the time information generation circuit is configured to output the time information signal resulting from taking a logical sum of the detection signals output from the plurality of SSPDs.

3. The signal processing circuit according to claim 1 or 2, comprising an encoder circuit (21A) serving as the address information generation circuit, the encoder circuit being configured to convert the detection signals output from the plurality of SSPDs into a binary code of a predetermined number of bits to generate a pulse train corresponding to the binary code.

4. The signal processing circuit according to claim 1 or 2, comprising a pulse position modulation circuit (21B) serving as the address information generation circuit, the pulse position modulation circuit being configured to make delay times of detection signals transmitted through the second transmission paths different from each other.

## Patentansprüche

1. Signalverarbeitungsschaltung, die mit einer supraleitenden digitalen Logikschaltung konfiguriert ist und zur Verarbeitung von Detektionssignalen konfiguriert ist, die von einer Vielzahl von supraleitenden Einzelphotonen-Detektoren, SSPD, (100) ausgegeben werden, wobei die Signalverarbeitungsschaltung umfasst:
eine Vielzahl von Übertragungswegen (25), die eins zu eins mit der Vielzahl von SSPDs verbunden sind;
eine Verzweigungseinheit (26), die bewirkt, dass jeder der Übertragungswege in einen ersten Übertragungsweg (25A) und einen zweiten Übertragungsweg (25B) verzweigt wird;
eine Zeitinformations-Erzeugungsschaltung (20), die mit den ersten Übertragungswegen verbunden ist; und
eine Adressinformations-Erzeugungsschaltung (21), die mit den zweiten Übertragungswegen verbunden ist,
wobei
die Zeitinformations-Erzeugungsschaltung konfiguriert ist, um auf der Grundlage der von der Vielzahl von SSPDs ausgegebenen Detektionssignale ein Zeit- (Timing-) Informationssignal zum Identifizieren einer Zeit, zu der ein Photon auf die Vielzahl von SSPDs auftrifft, auszugeben, und
die Adressinformations-Erzeugungsschaltung konfiguriert ist, um auf der Grundlage der von der Vielzahl von SSPDs ausgegebenen Detektionssignale ein Adressinformationssignal zum Identifizieren einer SSPD, auf die ein Photon auftrifft, aus der Vielzahl von SSPDs auszugeben.

2. Signalverarbeitungsschaltung nach Anspruch 1, wobei
die Zeitinformations-Erzeugungsschaltung konfiguriert ist, um das Zeitinformationssignal auszugeben, das sich aus der Bildung einer logischen Summe der Detektionssignale ergibt, die von der Vielzahl von SSPDs ausgegeben werden.

3. Signalverarbeitungsschaltung nach Anspruch 1 oder 2, umfassend eine Codierschaltung (21A), die als die Adressinformations-Erzeugungsschaltung dient, wobei die Codierschaltung konfiguriert ist, um die von der Vielzahl von SSPDs ausgegebenen Detektionssignale in einen Binärcode einer vorbestimmten Anzahl von Bits umzuwandeln, um eine dem Binärcode entsprechende Impulsfolge zu erzeugen.

4. Signalverarbeitungsschaltung nach Anspruch 1 oder 2, umfassend eine Impulspositions-Modulationsschaltung (21B), die als die Adressinformations-Erzeugungsschaltung dient, wobei die Impulspositions-Modulationsschaltung konfiguriert ist, um Verzögerungszeiten von Detektionssignalen, die durch die zweiten Übertragungswege übertragen werden, voneinander unterschiedlich zu machen.

## Revendications

1. Circuit de traitement de signal configuré avec un circuit logique numérique supraconducteur et configuré pour traiter des signaux de détection délivrés depuis une pluralité de détecteurs monophotoniques supraconducteurs, SSPD, (100), le circuit de traitement de signal comprenant :
une pluralité de voies de transmission (25) reliées à la pluralité de SSPD sur une base d'un à un ;
une unité de ramification (26) qui amène chacune des voies de transmission à se ramifier en une première voie de transmission (25A) et une seconde voie de transmission (25B) ;
un circuit de génération d'informations de temps (20) relié aux premières voies de transmission ; et
un circuit de génération d'informations d'adresse (21) relié aux secondes voies de transmission,
dans lequel
le circuit de génération d'informations de temps est configuré pour délivrer, sur la base des signaux de détection délivrés depuis la pluralité de SSPD, un signal d'informations de temps (timing) pour identifier un temps auquel un photon est incident sur la pluralité de SSPD, et
le circuit de génération d'informations de temps est configuré pour délivrer, sur la base des signaux de détection délivrés depuis la pluralité de SSPD, un signal d'informations d'adresse pour identifier un SSPD sur lequel un photon est incident parmi la pluralité de SSPD.

2. Circuit de traitement de signal selon la revendication 1, dans lequel
le circuit de génération d'informations de temps est configuré pour délivrer le signal d'informations de temps découlant de la prise d'une somme logique des signaux de détection délivrés depuis la pluralité de SSPD.

3. Circuit de traitement de signal selon la revendication 1 ou 2, comprenant un circuit codeur (21A) servant de circuit de génération d'informations d'adresse, le circuit codeur étant configuré pour convertir les signaux de détection délivrés depuis la pluralité de SSPD en un code binaire d'un nombre prédéterminé de bits pour générer un train d'impulsions correspondant au code binaire.

4. Circuit de traitement de signal selon la revendication 1 ou 2, comprenant un circuit de modulation de position d'impulsions (21B) servant de circuit de génération d'informations d'adresse, le circuit de modulation de position d'impulsions étant configuré pour faire en sorte que des temps de retard de signaux de détection transmis à travers les secondes voies de transmission soient différents les uns des autres.
